# EUROPEAN PATENT APPLICATION

(11) **EP 1 429 399 A2**
(43) Date of publication of application: **16.06.2004**
(21) Application number: 03018935.1
(22) Date of filing: 20.08.2003
(51) Int. Cl.: H01L 39/14, H01L 39/24

(54) **Superconducting wire rod and method of producing the same**

(30) Priority: 11.12.2002 JP 2002358972
(71) Applicant: Hitachi, Ltd., Chiyoda-ku, Tokyo 101-8010 (JP); Independent Administrative Institution National Institute for Materials Science, Tsukuba-shi, Ibaraki (JP)
(72) Inventor: Tanaka, Kazuhide, c/o Hitachi, Ltd., Chiyoda-ku, Tokyo 100-8220 (JP); Okada, Michiya, c/o Hitachi, Ltd., Chiyoda-ku, Tokyo 100-8220 (JP); Kumakura, Hiroaki, c/o Ind. Adm. Inst. Nat., Tsukuba-shi, Ibaraki 305-0047 (JP); Kitaguchi, Hitoshi, c/o Ind. Adm. Inst. Nat., Tsukuba-shi, Ibaraki 305-0047 (JP); Tokano, Kazumasa, c/o Ind. Adm. Inst. Nat., Tsukuba-shi, Ibaraki 305-0047 (JP)
(74) Representative: Strehl Schübel-Hopf & Partner

(57) **Abstract**

The invention provides a superconducting wire rod which is filled with or interiorly includes a superconductor containing boron, wherein the superconducting wire rod (1) has a practical critical electric density even under a magnetic field. In a superconducting wire rod filled with or interiorly including a superconductor (3) containing boron, a metal powder is added to the superconducting material included in the superconducting wire rod, the metal powder is selected from at least one of indium, tin, lead, iron, magnesium and aluminum, the metal powder having an average grain diameter equal to or less than 20 µm is dispersed with 5 to 25 vol% in the superconducting material, a density of the superconducting material included in the superconducting wire rod after a final work is equal to or more than 90% a theoretical density, and a critical current density is equal to or more than 1000 A/cm².

## Description

### BACKGROUND OF THE INVENTION

### Field of the Invention

The present invention relates to a super-conducting wire rod in which a high superconducting critical current density can be obtained by using a superconducting material expressing a superconductivity under an environment below a critical temperature, a method of producing the superconducting wire rod, and a superconducting magnet using the superconducting wire rod.

In particular, the present invention relates to a superconducting wire rod which is applied to a current lead, an electric power transmission cable, a large size magnet, a nuclear magnetic resonance analyzing apparatus, a medical magnetic resonance diagnosing apparatus, a superconducting electric power storage apparatus, a magnetic separating apparatus, a magnetic single crystal pulling apparatus, a refrigerator cooling superconducting magnet apparatus, a superconducting energy storage, a superconducting generator, a magnet for nuclear fusion reactor, and the like.

### Description of the Prior Art

In conventional, as the superconducting material, there has been known metals such as a niobium titanium (NbTi), a niobium tin (Nb₃Sn) and the like. However, these superconductive metals have a problem that it is necessary to use an expensive liquid helium for cooling, because a critical temperature is low, for example, the critical temperature is 23 K (Kelvin) even in a niobium germanium (Nb₃Ge) having the highest critical temperature.

On the other hand, in a high-temperature superconductor, after a superconductor of a lantern (La) oxide having a critical temperature of 30 K was found in April 1986, an yttrium (Y) group, a bismuth (Bi) group, a thallium (Tl) group and a hydrargyrum (Hg) group in which the critical temperature is over a boiling temperature (77K) of a liquid nitrogen were found one after the other.

However, since these copper group oxides are composed of a so-called ceramic, it is hard to work and a defect in a cross section homogeneity exists in a long wire more than some tens m.

Entering into twenty first century, as was reported by a non-patent document 1 (Nature 410, 63-64 (2001)), it was found that a magnesium boride (MgB₂) expresses a superconduction at about 40 K.

Since this material has an extremely small magnetic field anisotropy, a practical critical current density can be obtained without necessity of aligning a crystal orientation with a substrate as in the copper oxide. Further, the inventors of the present application make it appear that this material is extremely excellent in a bending property, and a critical current density equal to or more than 90% can be maintained with respect to a wire rod with no strain even when a strain of 1.5% is applied to the superconducting wire.

Further, there is an advantage that a critical temperature is 20 K or more higher than that of the metal superconducting material, or a report that the critical magnetic field is about 20 T in a normal tape wire, and about 40 T in a thin film, as described in a non-patent document 2 (cond-mat/0108265). It is considered that an application in a strong magnetic field is practical by using these properties.

Further, it has been known that a practical critical current density can be obtained only by a machine work, in this material. This material has an absolutely different property from that of the conventional superconducting wire rod which expresses a superconducting phenomenon only by applying a heat treatment. It is possible to achieve the following items by utilizing this property:
(1) it is possible to shorten a production process;
(2) it is possible to expand a range of choice of a metal coating material; and
(3) it is possible to improve a coil winding and a degree of freedom in a design.

Accordingly, it is considered that a cost can be widely reduced.

At a time of producing the oxide super-conducting wire rod, since it is possible to produce the wire rod in accordance with a normally used "powder in tube method", this material is positioned as an extremely attractive material.

Further, if the practical superconducting property can be maintained by the MgB₂ group wire rod, it can be expected to contribute to various fields, for example, an application to a biological science which is one of fields in the spotlight in recent years, in addition to a power application such as an electric power transmission cable or the like.

However, the MgB₂ group superconducting wire rod which has been produced by way of trial has a problem that a critical current density, an upper critical magnetic field and an irreversible magnetic field are low in comparison with the conventional metal group and the oxide group superconductor.

In particular, with respect to the critical current density, a value over 10⁵ A/cm² in a temperature range equal to or less than 20 K is reported in a short wire rod of some cm order, however, in a long wire rod of some m order, the performance can not be maintained, and the critical current density is about single-digit lowered in comparison with the short wire rod. Accordingly, particularly considering a practical use using the long wire rod, it is necessary to widely improve the critical current density.

In order to solve the problems mentioned above, those skilled in the art devote themselves to consider combining MgB₂ under a high pressure, promoting a single phase of MgB₂, improving a bonding property between crystal grains by adding a metal powder to MgB₂, and the like.

However, there has not been obtained an MgB₂ group superconducting wire rod which can maintain the practical critical current density, upper portion critical magnetic field and irreversible magnetic field even in the long wire rod.

### SUMMARY OF THE INVENTION

Taking the above matters into consideration, an object of the present invention is to provide a superconducting wire rod which is filled with or interiorly includes a superconductor containing a boron, wherein the superconducting wire rod has a practical critical electric density even under a magnetic field, and a method of producing the superconducting wire rod.

The inventors of the present invention have advanced research and development for the purpose of aiming mainly to an application of an oxide superconductor and a magnet using the oxide superconductor. During this step, it has been clarified that the following four items are particularly important as items for improving a critical current density.
(1) choice of metal coating material which does not thermally react with the superconductor
(2) charging density of the superconductor at a time of working in a final shape
(3) improvement of bonding property between crystal grains
(4) introduction of a pinning center which traps quantized magnetic flux lines and makes the invading magnetic flux lines unmovable

A superconducting wire rod having a high property can be obtained by simultaneously achieving the four items mentioned above. However, the critical current density is not a specific value for the material, but depends widely upon a producing method. Accordingly, it is known that the critical current density is not so improved only by the oxide superconducting metal rod or the method which has been applied to the metal group superconducting wire rod. That is, it is necessary to optimize the critical current density in correspondence to the material, and it is necessary to make an independent consideration in the superconductor containing the boron.

Accordingly, the inventors of the present invention have paid attention to solving the problems mentioned above. As a result, the inventors of the present invention has found a novel superconducting wire rod and a method of producing the novel superconducting wire, which can widely improve a superconducting property in comparison with the conventional superconducting wire rod and the conventional superconducting coil using the long wire rod.

That is, the object mentioned above can be achieved by a superconducting wire rod filled with or interiorly including a superconductor containing a boron, in which a metal powder is added to a superconducting material included in the super-conducting wire rod, an element of the metal powder is selected from at least one of an indium, a tin, a lead, an iron, a magnesium and an aluminum, the metal power having an average grain diameter equal to or less than 20 µm is 5 to 25 vol% dispersed in the superconducting material, a density of the superconducting material included in the superconducting wire rod after a final work is equal to or more than 90% a theoretical density, and a critical current density is equal to or more than 1000 A/cm².

Further, the object mentioned above can be achieved by a superconducting wire rod in which a defect portion having an area equal to or more than 10 mm² does not exist over an entire length of the wire rod, on a surface of the superconducting wire rod.

Further, the object mentioned above can be achieved by a superconducting wire rod in which an allowable bending strain rate ε (%) (ε = (t/2r) x 100) capable of maintaining a critical current density Jc(1) 90% equal to or more than a critical current density Jc(0) at a time when no bending is applied to the wire rod is equal to or more than 0.8%, on the assumption that an entire thickness of the superconducting wire rod is set to t (mm), a radius of bending is set to r (mm), and a rate of bending strain is set to ε (%).

Further, the object mentioned above can be achieved by a superconducting wire rod having a cross section structure in which the superconductor containing the boron is made complex compound with a different kind of superconductor. At this time, in the case that the different kind of superconductor other than the superconductor containing the boron is a niobium titanium, a more effect can be obtained.

Further, the connection between the superconducting wire rods mentioned above can be achieved by using a connecting method corresponding to a bonding via the superconductor containing the boron.

Further, the object mentioned above can be achieved by a method of producing a superconducting wire rod comprising:
a step of charging a metal power selected from at least one of an indium, a tin, a lead, an iron, a magnesium and an aluminum of 5 to 25 vol% in a superconducting powder containing a boron or a precursor powder to a metal pipe; and
a step of wiring and/or rolling the metal pipe,
wherein a density of a superconducting material contained in the superconducting wire rod after a final process is equal to or more than 90%, and a critical current density is equal to or more than 1000 A/cm².

At this time, there can be obtained an extremely great effect that a production cost can be widely reduced, by applying no heat treatment step to the superconducting wire rod during the production step of producing the superconducting wire rod.

Further, it is possible to obtain the superconducting wire rod having an excellent critical current property in comparison with the conventional metal group superconducting wire rod in the magnetic field and in a temperature range over 20 K, by employing a method of producing a superconducting wire rod including a step of making the reduced metal pipe composite with different superconductor.

As a method of producing a superconductor, a sintered body or an agglomerate in the present invention, there can be listed up a method of crushing and mixing the respective chemical compounds and sintering the mixture.

This method includes a method of mixing all the raw material chemical compounds at one time, and a method of previously mixing a part of the raw material chemical compounds and thereafter mixing the remaining raw material powders. At this time, it is effective to add the metal powder of 5 to 25 vol%.

Further, it is effective that the metal powder is a metal powder which is selected from at least one of an indium, a tin, a lead, an iron, a magnesium and an aluminum.

A temperature of heat treatment for combining the superconducting powders in the present invention employs a temperature within a range between 400 and 1200°C. Further, the heat treatment is carried out by using an oxygen gas, a nitrogen gas, an argon gas, a hydrogen gas or the like independently or a mixture thereof, as occasion demands. Further, the heat treatment is carried out while pressurizing under a pressure equal to or more than an atmospheric pressure, as occasion demands.

With respect to a method of producing the superconducting wire rod in the present invention, there have been a lot of methods. Here, a description will be given in detail of a powder-in-tube method as one example thereof.

Materials obtained by crushing to a proper size and sintering after combining the superconductor or the precursor by the method mentioned above are charged into a pipe-like metal coating member. The metal coating member employs one or more selected from a silver, an aluminum, a copper, an iron, a platinum, a palladium, a nickel, a stainless, a chrome, a magnesium, a tantalum, a niobium, a titan, a tin, a beryllium, a tungsten and a cobalt.

Further, a copper-aluminum alloy (an arms bronze) may be an effective metal coating member. It goes without saying that the metal coating member does not thermally react with the superconductor, and it is further necessary to have a good workability in view of a mass production.

Further, in the case of forming the wire rod so as to have multiple cores, a plurality of metal coating members are arranged, however, the kind and the material can be made different.

In the above case, when the coating member has a dual structure, it is preferably that the metal coating members in an inner side and an outer side are made of a material which is not thermally reacted with the superconductor, however, it is more desirable that the outer metal coating member is made of a material which has a high strength in addition to the property concerning the reaction. Accordingly, there is an advantage that the metal coating member can serve both as a coating member and a reinforcing member. Further, in the case that an insulating film such as an oxygen film or the like is formed on a surface of the metal, it is possible to play a part of the insulating member.

The diameter reducing work of the wire rod is achieved by repeatedly carrying out a wire drawing work in which a reduction in area per 1 pass is about 1 to 20%, by using a drawing bench, a swager, a cassette roller die or a grooved roll. As occasion demands, the wire rod is made so as to have multiple cores, however, a method of making the wire rod so as to have multiple cores is achieved by assembling the wire rod wire drawn in a round cross sectional shape or a hexagonal cross sectional shape in the pipe, and wire drawing to a predetermined wire diameter with a reduction in area per 1 pass being about 1 to 20%, by using the apparatus mentioned above.

The process in this case has an effect of densifying a superconducting powder charged within the metal coating material as well as forming the wire rod in a desired shape. Further, in order to intend to densify further, a wire rod having a high critical current density can be obtained by working by a cold rolling mill or a hot rolling mill, forming a planer or a tape-like cross section and heat treating under a suitable temperature or atmosphere.

In the superconducting wire rod in accordance with the present invention, in the case that the density of the superconductor worked in the final shape is equal to or more than 90% of a theoretical density, the wire rod having a high critical current density can be obtained.

In the superconducting wire rod in accordance with the present invention, as described in page 148 of a lecture summary in No. 66 Spring Cryogenic Engineering and Superconducting Association in 2002, the boron group superconducting wire rod is excellent in a bending property, and the critical current density is not deteriorated even by being applied a bending strain about 1%. This is conventionally more excellent than the metal group superconducting wire rod or the oxide superconducting wire rod, and it is said that this is one of extremely great features.

A temperature between 200 and 1200°C is used as a final heat treatment temperature for the super-conducting wire rod in the present invention, however, a high critical current density can be obtained even if the heat treatment is not carried out.

The inventors of the present invention have confirmed on the basis of experiments that this is because a bonding property between the crystal grains becomes in a good state in a step of reducing the diameter of the wire rod or a step of deforming the wire rod. However, in order to improve the bonding property between the crystal grains, a heating process is effective, and the critical current density is 10% or more improved in some cases.

However, an average diameter of the crystal grains of the superconductor suitable for improving the critical current density is equal to or less than 20 µm, and the inventors have confirmed that the critical current density is reduced in the case that the grain diameter is more than 20 µm.

The produced wire rod is used by combining one or more wire rod so as to wind in a coil or forming in a lead wire or a cable wire in accordance with a purpose.

In the case of carrying out the heat treatment, in order to improve a property of the superconductor, a heat treatment atmosphere is selected in correspondence to the material. For example, the heat treatment is carried out under a state in which an oxygen gas, a nitrogen gas, an argon gas or a hydrogen gas is independently or a mixture thereof is flowed as a gas stream with a suitable flow rate or sealed.

Further, in the MgB₂ group superconductor, there is a case that the magnesium having a high vapor pressure is scattered during the heat treatment so as to generate a composition shift, and the super-conducting property is deteriorated. In this case, it is effective to apply a heat treatment in a state of forming a pseudo-magnesium atmosphere, for example, by simultaneously carrying out a heat treatment of the magnesium sintered body or the like. Further, the same effect can be obtained by making the metal coating member include the magnesium.

Further, the bonding property between the crystal grains is improved by adding the metal powder having a lower melting point than that of the superconductor in the present invention, and a high critical current density can be obtained. The added metal is dispersed to the crystal grain boundary of the superconductor and within the grains, whereby it is possible to increase a pinning force.

Further, paying attention to a possibility of proximity effect between the crystal grains utilizing a great *ξ* in the MgB₂ superconductor, it is attempted to improve the bonding property between the crystal grains.

As an element of the metal powder, the indium, the tin or the lead corresponding to a material having a low melting point is desirable, however, the iron, the magnesium or the aluminum may be contained.
Further, it is desirable that the average diameter of the crystal grains is equal to or less than 20 µm. This is because the additional metal is a non-superconducting layer and an electric current pass is shut off in the case that it is larger than the grain diameter of the superconducting layer.

Further, it is not preferable if an amount to be added is too small or too much. The inventors of the present invention have confirmed on the basis of the experiments that 5 to 25% additional amount is required with respect to the volume rate of the superconductor.

In the production step of the wire rod in accordance with the present invention, it is necessary to apply a work in which the reduction in area is equal to or more than 5%, preferably equal to or more than 10%, at a time of the final working process of working the superconducting wire rod in the final shape. The wire drawing work or the metal rolling work for reducing the cross section has an effect of densifying the superconductor charged within the metal coating member as mentioned above.

Further, the same effect can be obtained by applying a pressure equal to or more than 1 ton/cm² to the superconducting wire rod so as to deform the superconducting wire rod.

Since these methods mentioned above improve the bonding property between the crystal grains, the critical current density is improved. Further, the inventors of the present invention have clarified that one of the superconductor and the added metal powder or a part of the both is melted at a time of the diameter reducing work or the deforming work, whereby the bonding property between the crystal grains is further improved.

In addition to the methods mentioned above, it is possible to employ, for example, a flame spray coating method, a doctor blade method, a dip coat method, a spray pyrolysis method, a jelly roll method and the like. The same superconducting property can be obtained even by using the wire rod produced in accordance with these methods.

Further, in the superconducting wire rod in accordance with the present invention, a mechanical strength such as a yield stress of the wire rod itself, a tensile strength, a Young's modulus and the like is extremely high, and it is possible to construct a magnet capable of standing against an electromagnetic force at a time when a high magnetic field is generated. Further, a permanent current magnet can be achieved by making both end resistances sufficiently small.

Further, in the case of using the superconductor produced in accordance with the present invention, for example, in a liquid helium, a practical conductor such as a superconducting magnet or the like generating a higher magnetic field can be achieved by making the structure so as to be combined with the metal group superconductor or the oxide superconductor.

As the metal group superconductor at this time, an NbTi group alloy, an Nb₃Sn group chemical compound, an Nb₃Al group chemical compound, a V₃Ga group, a Chevrel group compound or the like is employed, and two or more kinds of magnets are arranged as occasion demands. It is desirable that the oxide superconductor at this time is a superconductor of Y group, Bi group, Tl group, Hg group and Ag-Pb group.

Further, in the case of using the superconductor produced in accordance with the present invention in a liquid hydrogen and a liquid neon, a practical conductor such as a superconducting magnet having a higher performance can be achieved by combining with the oxide superconductor.

The superconducting wire rod can be used in a power transmission cable, an electric current lead, an MRI apparatus, an NMR apparatus, an SMES apparatus, a superconducting power generator, a superconducting motor, a magnetic levitated train, a superconducting electromagnetic thrust ship, a superconducting transformer, a superconducting current limiting device and the like.

Further, the conductor in which the superconducting wire rod is worked in a desired shape is installed after being deformed and worked for a conductor such as a coil, an electric current lead, a cable or the like. Further, if a used temperature is equal to or more than a liquid hydrogen temperature or a liquid neon temperature, a further effective result can be obtained. Next, a description will be given of the present invention by showing embodiments.

Other objects, features and advantages of the invention will become apparent from the following description of the embodiments of the invention taken in conjunction with the accompanying drawings.

### BRIEF DESCRIPTION OF THE DRAWINGS

Fig. 1 is a cross sectional schematic view of a round superconducting wire rod in accordance with the present invention;
Fig. 2 is a cross sectional schematic view of a tape-shaped superconducting wire rod in accordance with the present invention;
Fig. 3 is a view showing one example of a step for producing the superconducting wire rod in accordance with the present invention;
Fig. 4 is a graph showing a relation between a bending strain rate and a standardized critical current density in each of various superconducting wire rods produced in accordance with the present invention;
Fig. 5 is a cross sectional schematic view of a combined superconducting wire rod in accordance with the present invention;
Fig. 6 is a cross sectional schematic view of a combined superconducting wire rod in accordance with the present invention;
Fig. 7 is a cross sectional schematic view of a combined superconducting wire rod in accordance with the present invention;
Fig. 8 is a cross sectional schematic view of a combined superconducting wire rod in accordance with the present invention;
Fig. 9 is a graph showing a temperature dependence of a critical current density in each of various superconducting wire rods produced in accordance with the present invention;
Fig. 10 is a cross sectional schematic view showing a connection of the superconducting wire rod in accordance with the present invention; and
Fig. 11 is a cross sectional schematic view showing a connection of the superconducting wire rod in accordance with the present invention.

### DESCRIPTION OF THE PREFERRED EMBODIMENT

### Embodiment 1

A magnesium powder (Mg purity: 99%) and an amorphous boron powder (B purity: 99%) are used as a starting material, they are weighed so that the magnesium and the boron constitute an atomic mole ratio 1 : 2, and are mixed for 10 to 60 minutes.

Next, this mixture is thermally treated at 700 to 1000°C and for 2 to 20 hour, and the MgB₂ superconductor is produced. At this time, the heat treatment may be carried out after applying a pressure equal to or more than the atmospheric pressure.

As a result of applying an X-ray diffraction analysis to the obtained powder, it is known that the MgB₂ superconductor is contained at a rate equal to or more than 95% in an intensity ratio conversion. In addition to the MgB₂, a slight amount of MgO and MgB₄ are contained.

The mixed powder is produced by adding an indium metal powder having an average grain diameter equal to or more than 20 µm independently at an amount of 0.1 to 40 vol% to the MgB₂ superconducting powder produced in accordance with the method mentioned above and mixing for 10 to 60 minutes.

The obtained mixed powder is charged to a stainless steel pipe having a circular cross sectional shape with an outer diameter 10 mm and an inner diameter 8 mm. At this time, in addition to charging in the powder state, a columnar or a rectangular rod produced by a press molding or the like may be charged. This is exposed to a wire drawing with the reduction rate of cross sectional area 3 to 20%, and is reduced in diameter to a predetermined shape. As occasion demands, a transversal cross sectional shape of the wire rod is worked in an oval shape, a hexagonal shape, a rectangular shape or a round shape so as to reduce an area.

In the present invention, the diameter reduction work is applied until a tape-shaped wire rod having a thickness 0.2 to 0.5 mm and a width 2 to 5 mm is obtained.

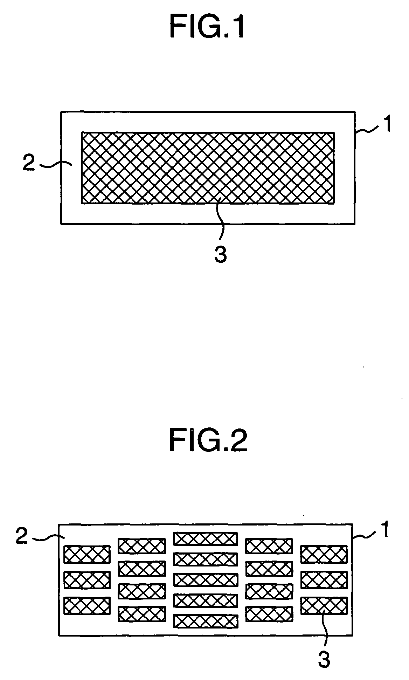

Fig. 1 shows one example of a cross sectional schematic view of a produced superconducting wire rod 1. The superconducting wire rod 1 is structured such that an MgB₂ superconductor 3 is charged or internally included in a metal coating member 2. Further, in this case, a heating process such as a heat treatment, an annealing or the like is not absolutely carried out at a time of working the wire rod. Further, it is possible to form a multi-core wire in which about 7 to 1320 MgB₂ superconductors 3 are installed, as shown in Fig. 2 as the case may be.

In this case, a thickness of the tape-like wire rod, a width thereof and an aspect ratio corresponding to a rate between the thickness and the width are not limited, and it is possible to work in various wire rod shapes, for example, from a round shape or a shape close to the round to a wide ultrathin tape shape.

An outer diameter of the wire rod having the circular shape, the oval shape, the rectangular shape or the hexagonal shape is preferably set to about 1 to 2 mm practically in a portion having a shortest opposite side, however, can be set to a suitable outer diameter and size in correspondence to an application and a resistance welding current.

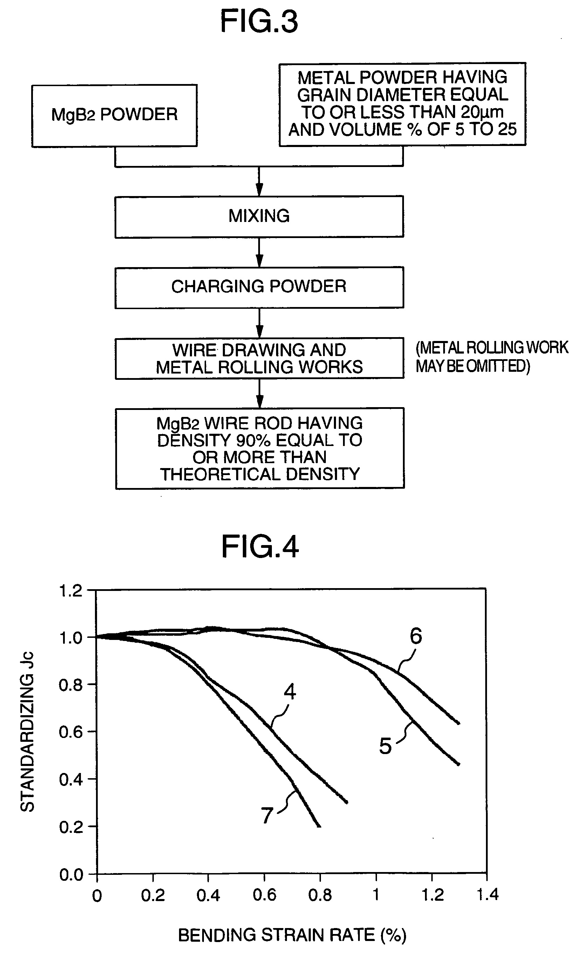

Fig. 3 shows one example of a step of producing the MgB₂ wire rod produced in accordance with the present embodiment. As described above, it is important to apply a diameter reduction work until a density of the superconductor is finally 90% a theoretical density.

Measuring the critical temperature of the wire rod produced in the present embodiment in accordance with a direct-current four-terminal method, it can be confirmed that an electrical resistance becomes zero at a temperature between 35 and 38 K in all the wire rods, in the case that the additional amount of the mixed powder is between 1 and 25 vol%. However, if the additional amount is more than 25 vol%, the critical temperature is lowered to be equal to or less than 30 K.

Next, the critical current density of each of the produced wire rods is measured under the temperature 4.2 K and the magnetic field 0.2 T. In this case, a critical current density of an additive-free wire rod to which no metal powder is added and which is produced as a comparative member under the temperature 4.2 K and the magnetic field 0.2 T is (3-4) x 10⁴ A/cm².

First, an effect of adding the indium powder is considered. As a result, as shown in Table 1, it becomes apparent that the critical current density is largely improved by adding the indium powder at 5 to 25 vol% to the MgB₂ powder.

On the basis of the result mentioned above, an effect of adding the other various metals than the indium is considered. In particular, each of the mixed powders is produced by adding independently each of the metal powders constituted by the tin, the lead, the iron, the magnesium, the aluminum, the gold and the silver each having the average grain diameter of 20 µm or less at 0.1 to 40 vol% to the MgB₂ superconducting powder.

Further, the mixed powder is also produced by mixing the metal powders of the indium and the tin and adding and mixing this mixed metal powder to the MgB₂ superconducting powder. At this time, the mixture is weighed so that one half is the indium and one half is the tin with respect to the added volume.

That is, in the case of adding 20 vol% to the MgB₂ superconducting powder, the indium powder and the tin powder are respectively added at 10 vol%, and are totally at 20 vol%.

The critical current density (x 10⁴ A/cm²) of each of the produced wire rods is measured under the temperature 4.2 K and the magnetic field 0.2 T. Results of measurement are shown in Fig. 1.

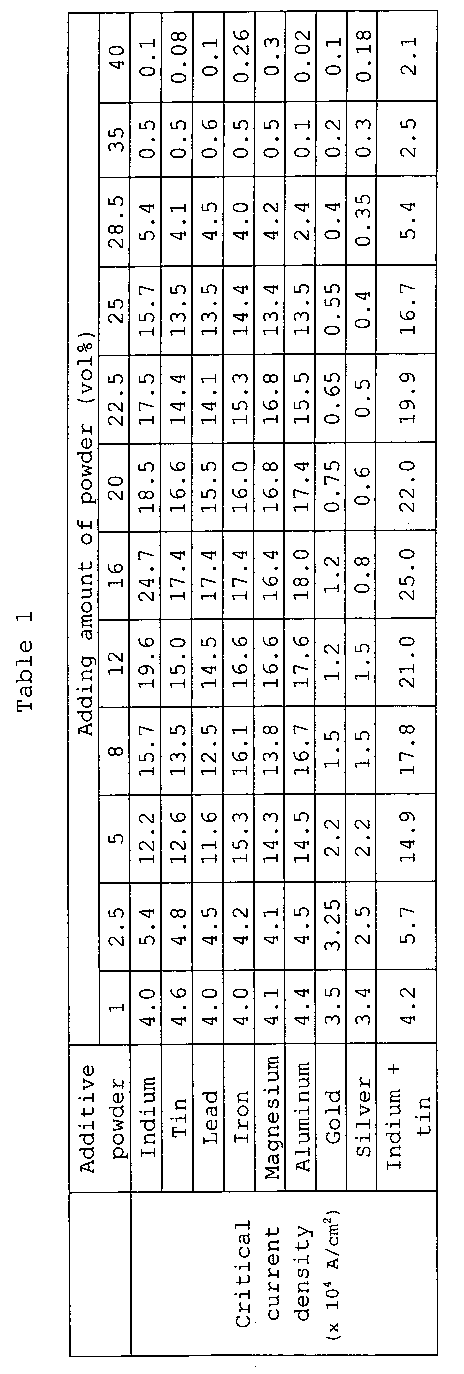

As mentioned above, it is known that the critical current density is largely improved by adding the indium powder having the grain diameter equal to or less than 20 µm, or each of the metal powders constituted by the tin, the lead, the iron, the magnesium and the aluminum, or the mixed metal powder of the indium and the tin at 5 to 25 vol% to the MgB₂ powder.

Next, in the wire rod in which the indium powder having the grain diameter equal to or less than 20 µm is added at 16 vol%, a relation between the density (%) of the superconductor and the critical current density in the superconducting wire rod after the final process is considered. Results of the consideration are shown in Table 2. The density of the superconductor is a value on the basis of the theoretical density, and is shown in percent figures. In this case, the density is changed by adjusting a degree of processing of the wire rod.

Further, in the present embodiment, the density of the charged powder is set to 50% the theoretical density, and the critical current density (x 10⁴ A/cm²) is measured under the temperature 4.2 K and the magnetic field 0.2 T.

### [Table 2]

**Table 2**

| | | | | | | | | |
|---|---|---|---|---|---|---|---|---|
| Density of superconducting material (%) | 50 | 65 | 75 | 85 | 90 | 93 | 97 | 99 |
| Critical current density (x 10⁴ A/cm²) | 0.5 | 1.1 | 2.9 | 4.1 | 24.0 | 24.4 | 24.7 | 24.7 |

As mentioned above, in the case that the indium powder is added at 16 vol%, it is apparent that the critical current density is largely improved when the density of the superconductor contained in the superconducting wire rod is more than 90% in regard to the theoretical density.

Further, on the basis of subsequent detailed experiments, in the case that the indium powder is added at 5 to 25 vol%, it is also confirmed that the critical current density is largely improved when the density of the superconductor contained in the superconducting wire rod is more than 90% in regard to the theoretical density.

Further, a consideration of the density of the critical current density of the superconductor is carried out by using the superconducting wire rods obtained by respectively adding the metal powders constituted by the tin, the lead, the iron, the magnesium and the aluminum each having the grain diameter equal to or less than 20 µm, and the mixed metal powder of the indium and the tin to the MgB₂ powder at 5 to 25 vol%.

As a result, it is known in the same manner as the case that the indium powder is added, that the critical current density becomes great when the density of the superconductor contained in the superconducting wire rod is more than 90% of the theoretical density. That is, it can be confirmed that the density of the superconductor becomes equal to or more than 90% of the theoretical density in the metal powder additive wire rod in which the critical current density is improved in comparison with the additive-free wire rod.

Next, as a result of observing a cross section of each of the wire rods by a scanning electron microscope, the added metal element can not be found. Further, as a result of observing the cross section by a transmission electron microscope, it is confirmed that the metal element exists in a crystal grain boundary of the superconductor.

Accordingly, it is considered that the critical current density is improved because the added metal powder improves a bonding property between the crystal grains. In particular, in the case of adding the metal having a lower melting point than the superconductor, it is known that the metal permeates into the crystal grain boundary. It is assumed that this is because the metal is melted by a working heat at a time of working the wire rod.

On the other hand, in the metal such as the magnesium, the aluminum or the like having a higher melting point than the superconductor, it is confirmed that they exist within the crystal grains, and act as a pinning center.

Further, in accordance with the cross section observation, it is known that a relation between the average diameter of the crystal grains in the superconductor and the average diameter of the crystal grains of the added metal powder is important for making the critical current density of the wire rod high. That is, it is known that every effect can be obtained only in the case that the average diameter of the crystal grains of the superconductor is larger than that of the metal powder, and otherwise, the critical temperature and the critical current density are lowered.

Further, it is preferable that each of the average diameters of the crystal grains of the superconductor and the added metal is small, and the critical current density considered in the present embodiment can be obtained within a range between 1 and 20 µm. On the contrary, it is known that when the critical current density is more than 20 µm, the critical current density is lowered in accordance with an increase of the average diameter of the crystal grains.

From the results mentioned above, it becomes apparent that it is effective for making the critical current density of the wire rod high to make each of the average diameters of the crystal grains equal to or less than 20 µm, in the superconductor and the added metal.

The present embodiment relates to the results of consideration in the stainless steel sheathe superconducting wire rod, however, the same results as mentioned above can be obtained, for example, in the case of using a metal having a Vickers hardness equal to or more than 150 such as an Ni, an Ni base alloy, a Cu base alloy or the like.

### Embodiment 2

A mixed powder is produced by adding a metal powder obtained by mixing the indium and the tin having the diameter equal to or less than 20 µm at an amount 15 vol% (indium: 7.5 vol%, tin: 7.5 vol%) to the MgB₂ powder.

The wire rod as shown in Fig. 1 is produced in the same manner as that of the embodiment 1 except charging the mixed powder to a stainless steel pipe having a circular cross sectional shape with an outer diameter 7 mm x 6 mm. In this case, since in this wire rod, a sheathe thickness is thinner than that of the embodiment 1, a sheathe rate in an entire of the wire rod is small. Therefore, a crack is generated over an entire length.

In the present embodiment, in order to clarify what degree a magnitude of an area of the crack generated over the entire length affects the critical current density, a consideration is given of a relation between an area of a working defect such as the crack or the like generated in the wire rod, and the critical current density, and results of consideration are shown in Table 3.

In this case, the area of the working defect here is defined as an area in which the superconductor in the superconducting wire rod is deposited on a surface. The critical current density is measured under the temperature 4.2 K and the magnetic field 0.2 T, and in a state in which a voltage terminal is mounted so that the defect portion is positioned in a center.

### [Table 3]

**Table 3**

| | | | | | | | | |
|---|---|---|---|---|---|---|---|---|
| Area of defect portion (mm²) | 0 | 2 | 5 | 8 | 10 | 12.5 | 15 | 20 |
| Critical current density (x 10⁴ A/cm²) | 22 | 20 | 19 | 19 | 6 | 6 | 2 | 1 |

On the basis of the results mentioned above, it is known that the critical current density is largely reduced if the defect portion having the area equal to or more than 10 mm² is generated on the surface of the superconducting wire rod. Therefore, it is known that in order to maintain a high critical current density, it is necessary to produce a wire rod in which any defect portion of 10 mm² or more does not exist over an entire length of the used wire rod.

The present embodiment corresponds to a result of consideration in the stainless steel sheathe superconducting wire rod, however, the same results as mentioned above can be obtained also in the case that the other metals are used as a sheathe member.

### Embodiment 3

An allowable bending strain rate is considered by using various wire rods produced in the embodiments 1 and 2. In practice, the following four kinds of wire rods are used:
(1) wire rod 4 in which a density of the superconductor after the final work is equal to or less than 90% the theoretical density;
(2) wire rod 5 in which a density of the superconductor after the final work is equal to or more than 90% the theoretical density;
(3) wire rod 6 in which a working defect generated on the surface is less than 10 mm²; and
(4) wire rod 7 in which a working defect generated on the surface is equal to or more than 10 mm².

In this case, the bending strain rate ε is determined by the formula ε = ((t/2r) x 100) (%). In this case, t is a thickness (mm) of an entire wire rod, and r is a radius of bending (mm). Results are shown in a graph in Fig. 4.

The critical current density is measured under the condition of the temperature 4.2 K and the magnetic field 0.2 T. In this case, the bending strain is measured by using a jig made of a brass and worked so as to have various r. Since the critical current density in the case that the bending is not be applied is different in correspondence to each of the wire rods, the critical current density of the wire rod to which the bending is not applied is standardized to 1.

As is mentioned in the embodiments 1 and 2, in the wire rod 5 in which the density of the superconductor after the final work (2) mentioned above having the high critical current density is equal to or more than 90% the theoretical density, and the wire rod 6 in which the working defect generated on the surface (3) is less than 10 mm², the allowable bending strain rate is between 0.9 and 1%. On the contrary, in the wire rod 4 in which the density of the superconductor after the final work (1) mentioned above having the low critical current density is equal to or less than 90% the theoretical density, and the wire rod 7 in which the working defect generated on the surface (4) is more than 10 mm², the allowable bending strain rate is lowered to 0.3 to 0.35%.

Accordingly, it is known that in the wire rod in which the density of the superconductor after the final work is equal to or more than 90% the theoretical density, and the working defect generated on the surface is less than 10 mm², the allowable bending strain rate becomes high.

The present embodiment corresponds to the results of consideration in the stainless steel sheathe superconducting wire rod, however, the same results as mentioned above can be also obtained in the case of using the other metals, in particular, a metal having a Vickers hardness equal to or more than 150 for the sheathe member.

### Embodiment 4

The mixed powder is prepared by adding the indium powder having the grain diameter equal to less than 20 µm at 16 vol% to the MgB₂ powder. This mixed powder is charged into a stainless steel pipe having a circular cross sectional shape with an outer diameter 8 mm and an inner diameter 6 mm. Thereafter, the wire drawing work is applied thereto by a reduction rate of cross sectional area 3 to 19%, and the diameter is reduced until the outer diameter becomes a desired diameter.

Next, for the purpose of combining with the different kinds of superconductors, the NbTi wire rod is produced. The producing method is briefly described below.

A single-core wire is obtained by hydrostatic extruding the NbTi and wire drawing the NbTi to a desired diameter after passing through an ingot step. The copper is coated around an outer periphery of the produced NbTi. Thereafter, a center of the wire rod is bored and formed in a pipe shape.

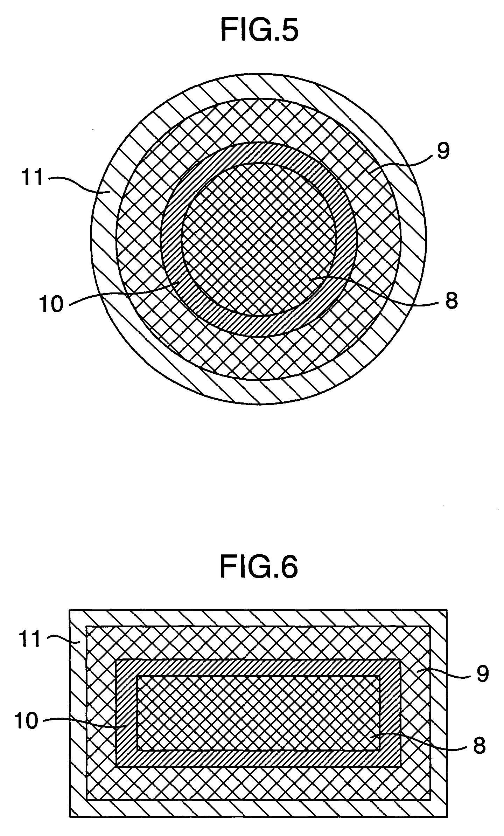

Next, a first superconductor 8 and a second superconductor 9 are combined so as to obtain a transversal cross sectional structure shown in Figs. 5 to 8. In the present embodiment, the MgB₂ superconductor is used for the first superconductor 8 and the NbTi superconductor is used for the second superconductor 9, however, the present effect can be obtained also in the other superconductors.

In Fig. 5, a stainless steel 10 is arranged in an interface between the MgB₂ superconductor 8 and the NbTi superconductor 9, and the copper is used for an outermost layer 11. In this case, there is no problem if a geometrical arrangement of the MgB₂ superconductor 8 and the NbTi superconductor 9 is inverse.

Further, a metal superconducting material of an Nb₃Sn group, an (NbTi)₃Sn group, Nb₃Al group, an Nb₃Ge group and V₃Ga group, or an oxide superconducting material of an Y group, a Bi group, a Ti group, an Ag-Pb group and an Hg group may be arranged in the NbTi superconductor 9.

For example, in the case of the combination between the MgB₂ superconductor 8 and the NbTi superconductor 9, a superconducting property of the NbTi superconductor can be mainly made good use until a certain temperature range by employing the arrangement mentioned above, and a superconducting property of the MgB₂ superconductor having the higher critical temperature can be made good use over the certain temperature range.

Further, an effective superconducting property can be obtained by combining two or more kinds of superconductors not only in the temperature but also an applied magnetic field, an applied angle or the like.

Fig. 6 shows approximately the same cross section as that in Fig. 5, however, is different in a flat cross sectional tape shape. In particular, in the case that the high critical current density is required, this shape is most effective. This is because a high density of the superconductor can be achieved by forming in the tape shape. It is further easy to apply to various applications by constructing the superconducting wire having the structure mentioned above.

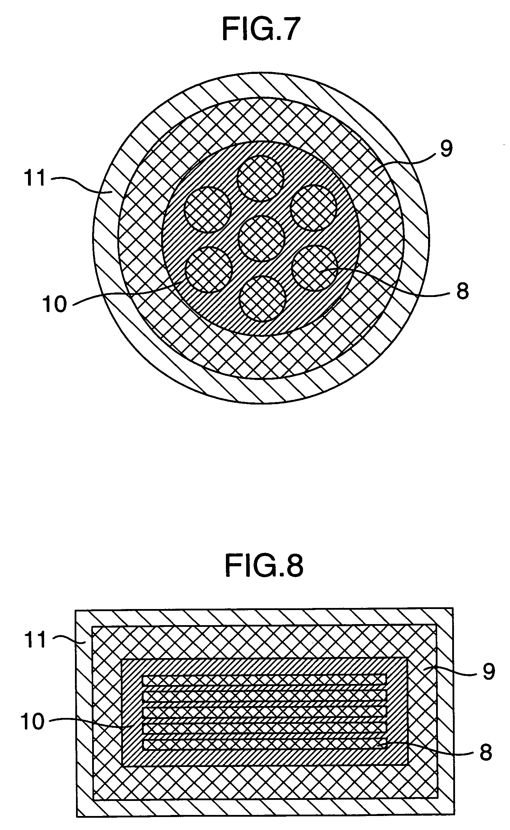

Fig. 7 is a transversal cross sectional view of a combined superconducting wire having a multi-core structure. That is, the MgB₂ superconductor 8 is arranged as a multi-core wire rod in the stainless steel 10. It is easy to twist the wire rod by making the structure as mentioned above, and there is obtained an advantage that an AC loss can be reduced.

Fig. 8 is a transversal cross sectional view of a combined superconducting wire having a flat-shaped multi-core structure. By making the structure as mentioned above, there is an effect that a high orientation is applied to the MgB₂ superconductor 8, and it is possible to obtain an excellent critical current property.

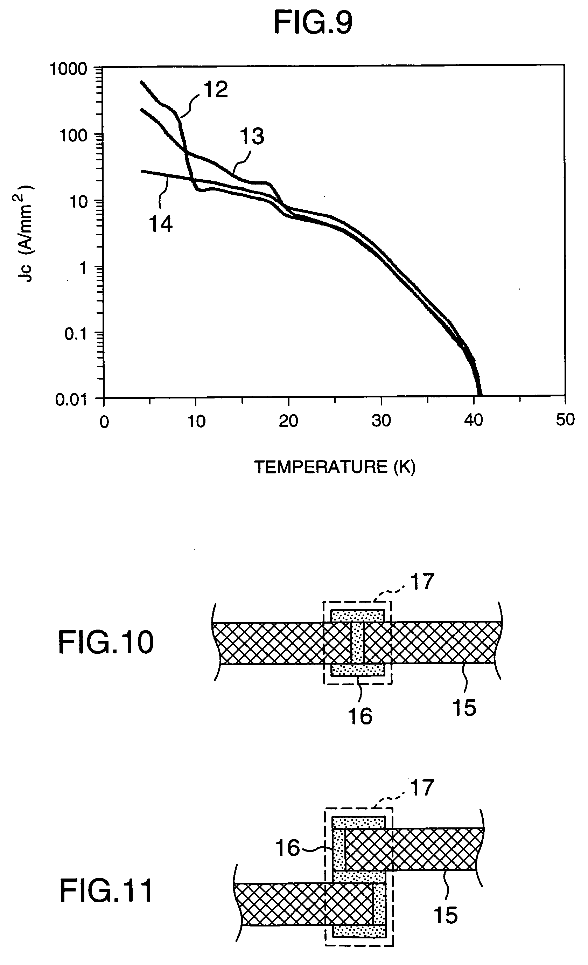

Fig. 9 has a cross sectional structure shown in Fig. 6.

This is a graph showing a combining effect in a temperature dependence of the critical current density under the temperature 4.2 K in the following wire rods:
(1) wire rod 12 obtained by combining the MgB₂ superconductor and the NbTi superconductor;
(2) wire rod 13 obtained by combining the MgB₂ superconductor and the Nb₃Al superconductor; and
(3) wire rod 14 only by the MgB₂ superconductor without being combined.

In comparison with the case of the wire rod 14 only by the MgB₂ without being combined, in the wire rod 12 obtained by combining the MgB₂ superconductor and the NbTi superconductor, the critical current property is improved particularly below 8 K.

Further, in the wire rod 13 obtained by combining the MgB₂ superconductor and the Nb₃Al superconductor, the critical current property is also improved below 15 K.

Further, as a result of measuring the magnetic field dependence of the critical current density in the wire rod 12 obtained by combining the MgB₂ superconductor and the NbTi superconductor, it is confirmed that the critical current density is widely improved under the magnetic field above 7 T. These are reasonable values taking into consideration the critical temperature and the critical magnetic field of each of the superconducting materials, and it is exemplified that even in the case that one of the combined superconducting wire loses a superconducting state, the superconducting state can be maintained by the remaining one, owing to the combined superconducting wire.

### Embodiment 5

Figs. 10 and 11 are schematic cross sectional views showing a connecting method between the combined superconducting wires in accordance with the present invention. The superconducting wires can be connected in a superconducting state by abutting the leading end portions of the single superconducting wires or the combined superconducting wire 15 produced in the manner mentioned above with each other, or overlapping the wires with each other, applying or coating the MgB₂ powder at 0.05 to 5 g to the surface thereof, and bonding under a pressure of about 1 ton/cm².

At this time, a more effective connection can be achieved by arranging a hard block-like metal 17 such as a stainless steel, an Ni, an Ni base alloy or the like in a portion to be pressurized. In accordance with this structure mentioned above, it is possible to obtain an effect of preventing the powder from being scattered.

In the present structure, for example, in the connection between the oxide group and the metal group, a resistance 10⁻¹⁰ Ω has conventionally existed, however, the resistance value is lowered to 10-14 Ω by using the combined superconducting wire 15 bonded in accordance with the connecting method on the basis of the present embodiment.

The above description relates to the junction using the combined superconducting wire, however, the junction may be applied to the single wire rod of each of the MgB₂ wire rod, the conventional metal group superconducting wire rod or the oxide superconducting wire rod, and it is confirmed that the present invention is a technique which can be applied to every types of wire rods.

Further, for the purpose of increasing a strength of the bonded portion, it is possible to increase the strength by impregnating and curing the bonded portion with an epoxy resin. The resin may employ a silicon group, an urethane group or the like, and can be selected in correspondence to the purpose.

The wire rod in accordance with the present invention can be applied widely to the superconducting devices, and an excellent effect that a high efficiency of the device can be achieved by applying the wire rod in accordance with the present invention, for example, to a large size magnet, a nuclear magnetic resonance analyzing apparatus, a medical magnetic resonance diagnosing apparatus, a superconducting electric power storage apparatus, a magnetic separating apparatus, a magnetic single crystal pulling apparatus, a refrigerator cooling superconducting magnet apparatus, and the like.

In accordance with the present invention, it is possible to obtain the superconducting wire rod having a practical critical current density.

Further, the superconducting wire rod and the superconducting magnet can be driven by being cooled by a liquid hydrogen, a liquid neon, a refrigerator conducting cooling or the like in addition to the liquid helium, and it is possible to obtain the superconducting wire rod having the high superconducting critical current density even in the magnetic field.

It should be further understood by those skilled in the art that the foregoing description has been made on embodiments of the invention and that various changes and modifications may be made in the invention without departing from the spirit of the invention and the scope of the appended claims.

## Claims

1. A superconducting wire rod filled with or interiorly including a superconductor containing boron, wherein a metal powder is added to a super-conducting material (3) included in said superconducting wire rod (1), said metal powder is selected from at least one of indium, tin, lead, iron, magnesium and aluminum, said metal powder having an average grain diameter equal to or less than 20 µm is 5 to 25 vol% dispersed in said superconducting material, a density of the superconducting material included in the superconducting wire rod after a final work is equal to or more than 90% a theoretical density, and a critical current density is equal to or more than 1000 A/cm².

2. A superconducting wire rod as claimed in claim 1, wherein a defect portion having an area equal to or more than 10 mm² does not exist over an entire length of the wire rod, on a surface of said superconducting wire rod.

3. A superconducting wire rod as claimed in claim 1, wherein in the case that a bending strain rate capable of maintaining a critical current density Jc(l) of 90% or more of a critical current density Jc(0) at a time when no bending is applied to the wire rod is defined as an allowable bending strain rate, the allowable bending strain rate ε (%) (ε = (t/2r) x 100) is equal to or more than 0.8%, on the assumption that an entire thickness of said superconducting wire rod is set to t, a radius of bending is set to r, and a rate of bending strain is set to ε.

4. A superconducting wire rod as claimed in claim 1, wherein said superconductor containing the boron is made of a complex compound with a different kind of superconductor.

5. A superconducting wire rod as claimed in claim 4, wherein said different kind of superconductor is niobium titanium.

6. A superconducting wire rod as claimed in claim 1, wherein a connection between superconducting wire rods mentioned above is achieved by using a connecting method corresponding to a bonding via the superconductor containing the boron.

7. A method of producing a superconducting wire rod comprising:
a step of mixing a metal powder having an average grain diameter equal to or less than 20 µm and selected from at least one of indium, tin, lead, iron, magnesium and aluminum of 5 to 25 vol% to a superconducting powder containing boron so as to produce a mixed powder;
a step of charging said mixed powder to a metal pipe; and
a step of wiring and/or rolling said metal pipe,
wherein a density of a superconducting material contained in the superconducting wire rod after a final process is equal to or more than 90%, and a critical current density is equal to or more than 1000 A/cm².
